(19)

Europäisches
Patentamt
European
Patent Office
Office européen
des brevets

(11) **EP 2 360 696 A1**

(12) **EUROPEAN PATENT APPLICATION**

(43) Date of publication:
24.08.2011 Bulletin 2011/34

(51) Int Cl.:
*G11B 20/18* (2006.01)    *G11B 5/596* (2006.01)

(21) Application number: 10251369.4

(22) Date of filing: 30.07.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(30) Priority: 24.02.2010 US 712136

(71) Applicant: LSI Corporation
Milpitas, CA 95035 (US)

(72) Inventors:
• Mathew, George
San José, CA 95123 (US)

• Yang, Shaohau
Santa Clara, CA 95135 (US)
• Xia, Haiteo
Mountain View, CA 94040 (US)
• Miladinovic, Nenad
Campbell, CA 95008 (US)

(74) Representative: Kenrick, Mark Lloyd et al
Marks & Clerk LLP
Sussex House
83-85 Mosley Street
Manchester
M2 3LG (GB)

(54) **Systems and methods for data recovery**

(57)    Various embodiments of the present invention provide systems and methods for identifying a reproducible location on a storage medium. As an example, a circuit is described that include a media defect detector and an anchor fixing circuit. The media defect detector is operable to identify a media defect, and the anchor fixing circuit is operable to identify a location relative to the media defect. The location is reproducible.

Fig. 1a

**EP 2 360 696 A1**

Fig. 1b

**Description**

BACKGROUND OF THE INVENTION

The present inventions are related to systems and methods for identifying a reproducible location on a storage medium, and more particularly to systems and methods for identifying a reproducible location on a storage medium based on a detected media defect.

A hard disk typically includes a number of user data regions that are preceded by synchronization information including a preamble and a data sync pattern. The preamble is used to synchronize phase and frequency during an asynchronous read, and the data sync pattern is used to define the starting point of a series of user data. In operation, a circuit searches for the data sync pattern and processes a series of subsequently received data samples derived at a location relative to the data sync pattern. Occasionally the data sync pattern is missed resulting in a retry where one or more search approaches are used to identify the data sync pattern. Such search approaches are often costly in terms of circuitry and time. Further, in some cases, the search approaches are not capable of identifying the data sync mark resulting in the loss of data.

Hence, for at least the aforementioned reasons, there exists a need in the art for advanced systems and methods for recovering data from a storage medium.

BRIEF SUMMARY OF THE INVENTION

The present inventions are related to systems and methods for identifying a reproducible location on a storage medium, and more particularly to systems and methods for identifying a reproducible location on a storage medium based on a detected media defect.

Various embodiments of the present invention provide circuits for identifying a reproducible location on a storage medium. Such circuits include a media defect detector and an anchor fixing circuit. The media defect detector is operable to identify a media defect, and the anchor fixing circuit is operable to identify a reproducible location relative to the media defect. In some cases, the media defect detector includes a discrete Fourier transform circuit that is tuned to a 2T pattern. In other cases, the media defect detector includes an end of preamble detector circuit.

In some instances of the aforementioned embodiments, the media defect detector is operable to identify a media defect using a series of data samples derived from a storage medium. In such instances, the circuit further includes a data processing circuit that is operable to process a subset of the series of data samples using a forced data sync mark that is a fixed distance from the location of the media defect. In some such instances, the circuit further includes a sync forcing circuit that is operable to repeatedly identify forced data sync marks whenever the data processing circuit fails to converge, and to store the forced data sync mark when the data processing circuit converges. In particular instances, the circuit further includes a data buffer that stores the forced data sync mark that is usable on subsequent reads from the storage medium to indicate the beginning of the decodable data set on the storage medium.

Other embodiments of the present invention provide methods for identifying a reproducible location on a storage medium. The method includes receiving a series of data samples derived from the storage medium; identifying a media defect on the storage medium using the series of data samples; and fixing or identifying a reproducible location on the storage medium relative to the media defect. In some cases, the methods further include applying a decoding algorithm to a subset of the series of data samples using the location as a reference for the beginning of a decodable data set. In some such instances where the decoding algorithm converges, the methods further include storing a forced data sync mark in a memory. The forced data sync mark indicates the location and is usable on subsequent reads from the storage medium to indicate the beginning of a decodable data set on the storage medium.

In various instances of the aforementioned embodiments, the location is a first location, and the method further includes: applying a decoding algorithm to a first subset of the series of data samples using the first location as a reference for the beginning of a decodable data set. Where the decoding algorithm fails to converge, the methods further include fixing a second location on the storage medium relative to the media defect that is reproducible; and applying the decoding algorithm to a second subset of the series of data samples using the second location as a reference for the beginning of the decodable data set. In some such cases, application of the decoding algorithm using the second location converges. In these cases, the methods may further include storing a forced data sync mark in a memory. The forced data sync mark indicates the second location and is usable on subsequent reads from the storage medium to indicate the beginning of the decodable data set on the storage medium. In one particular case, the second location is farther from the media defect than the first location.

In various instances of the aforementioned embodiments, the decoding algorithm is a low density parity check algorithm. In one or more instances of the aforementioned embodiments, receiving a series of data samples derived from a storage medium includes accessing the series of data samples from a data buffer. In some cases, the methods further include accessing information from the storage medium, and generating the series of data samples based upon the information.

Yet other embodiments of the present invention provide hard disk drive systems that include a storage medium, a media defect detector, and an anchor fixing circuit. The media defect detector is operable to identify a media defect on the storage medium using a series of data samples derived from the storage medium, and the anchor fixing circuit is operable to identify a location relative to the media defect. In such cases, the location is reproducible.

A first aspect of the invention provides a circuit for identifying a reproducible location on a storage medium, the circuit comprising: a media defect detector, wherein the media defect detector is operable to identify a media defect, and an anchor fixing circuit, wherein the anchor fixing circuit is operable to identify a location relative to the media defect, and wherein the location is reproducible.

The media defect detector may include a discrete Fourier transform circuit. The discrete Fourier transform circuit may be tuned to a 2T pattern.

The media defect detector may be operable to identify a media defect using a series of data samples derived from a storage medium, and wherein the circuit may further comprise: a data processing circuit, wherein the data processing circuit is operable to process a subset of the series of data samples using a forced data sync mark that is a fixed distance from the location.

The circuit may further comprise: a sync forcing circuit. The sync forcing circuit is operable to repeatedly identify forced data sync marks whenever the data processing circuit fails to converge, and to store the forced data sync mark when the data processing circuit converges. The circuit may further comprise: a data buffer, wherein the data buffer stores the forced data sync mark that is usable on subsequent reads from the storage medium to indicate the beginning of the decodable data set on the storage medium.

The media defect detector may include an end of preamble detector circuit.

A second aspect of the invention provides a method for identifying a reproducible location on a storage medium, the method comprising:

receiving a series of data samples derived from a storage medium;

identifying a media defect on the storage medium using the series of data samples; and

fixing a location on the storage medium relative to the media defect, wherein the location is reproducible.

The method may further comprise:

applying a decoding algorithm to a subset of the series of data samples using the location as a reference for the beginning of a decodable data set.

The decoding algorithm may converge, and the method may further comprise: storing a forced data sync mark in a memory, wherein the forced data sync mark indicates the location and is usable on subsequent reads from the storage medium to indicate the beginning of a decodable data set on the storage medium.

The location may be a first location, and the method may further comprise: applying a decoding algorithm to a first subset of the series of data samples using the first location as a reference for the beginning of a decodable data set, wherein the decoding algorithm fails to converge, fixing a second location on the storage medium relative to the media defect, wherein the second location is reproducible, and applying the decoding algorithm to a second subset of the series of data samples using the second location as a reference for the beginning of the decodable data set.

Application of the decoding algorithm using the second location converges, and wherein the method may further comprise:

storing a forced data sync mark in a memory. The forced data sync mark may indicate the second location and is usable on subsequent reads from the storage medium to indicate the beginning of the decodable data set on the storage medium. The second location may be farther from the media defect than the first location.

The decoding algorithm may be a low density parity check algorithm.

Receiving a series of data samples derived from a storage medium may include accessing the series of data samples from a data buffer.

The method may further comprises accessing information from the storage medium, and generating the series of data samples based upon the information.

A third aspect of the invention provides a hard disk drive system, the hard disk drive system comprising: a storage medium, a media defect detector, wherein the media defect detector is operable to identify a media defect on the storage medium using a series of data samples derived from the storage medium, and an anchor fixing circuit, wherein the anchor fixing circuit is operable to identify a location relative to the media defect, and wherein the location is reproducible.

The media defect detector may include a circuit selected from a group consisting of: a discrete Fourier transform circuit, and an end of preamble detector circuit.

The system further comprise a data processing circuit, wherein the data processing circuit is operable to process a subset of the series of data samples using a forced data sync mark that is a fixed distance from the location.

The system may further comprise a sync forcing circuit, wherein the sync forcing circuit is operable to repeatedly identify forced data sync marks whenever the data processing circuit fails to converge, and to store the forced data sync mark when the data processing circuit converges

The system may further comprise a data buffer, wherein the data buffer stores the forced data sync mark that is usable on subsequent reads from the storage medium to indicate the beginning of the decodable data set on the storage medium.

This summary provides only a general outline of some embodiments of the invention. Many other objects, features, advantages and other embodiments of the invention will become more fully apparent from the following detailed description, the appended claims and the accompanying drawings.

BRIEF DESCRIPTION OF THE DRAWINGS

A further understanding of the various embodiments of the present invention may be realized by reference to the figures which are described in remaining portions of the specification. In the figures, like reference numerals are used throughout several figures to refer to similar components. In some instances, a sub-label consisting of a lower case letter is associated with a reference numeral to denote one of multiple similar components. When reference is made to a reference numeral without specification to an existing sub-label, it is intended to refer to all such multiple similar components.

Fig. 1a depicts a read channel circuit including anchor point circuitry and data sync mark forcing circuitry in accordance with various embodiments of the present invention;

Fig. 1b is a timing diagram depicting an example operation of the read channel circuit of Fig. 1a in accordance with some embodiments of the present invention;

Fig. 2 shows a discrete Fourier transform based anchor location circuit in accordance with various embodiments of the present invention;

Fig. 3 shows an end of preamble based anchor location circuit in accordance with other embodiments of the present invention;

Figs. 4a and 4b are flow diagrams showing a method in accordance with some embodiments of the present invention for fixing an anchor point and forcing a data sync mark relative to the anchor point in accordance with one or more embodiments of the present invention; and

Fig. 5 shows a storage system including a read channel with anchor point circuitry and sync mark forcing circuitry in accordance with some embodiments of the present invention.

DETAILED DESCRIPTION OF THE INVENTION

The present inventions are related to systems and methods for identifying a reproducible location on a storage medium, and more particularly to systems and methods for identifying a reproducible location on a storage medium based on a detected media defect.

Various embodiments of the present invention provide forced data sync marks that may be used in place of original data sync marks that cannot be detected on a storage medium due to a media defect on the storage medium or some other anomaly. In one particular case, the forced data sync mark is located a defined distance from a media defect on the storage medium. As media defects do not move, the location of the media defect is reproducible. Because the location of the media defect is reproducible and the forced data sync mark is located relative to the media defect, the forced data sync mark is also reproducible. The reproducibility of the forced data sync mark allows for a forced data sync mark to be tested to determine its utility and once proven to be useful, the forced data sync mark may be used in the future to read data from the storage medium.

Some embodiments of the present invention provide circuits for identifying a reproducible location on a storage medium. Such circuits include a media defect detector and an anchor fixing circuit. As used herein, the phrase "media defect detector" is used in its broadest sense to mean any circuit, device or system that is capable of indicating a location of a media defect on a storage medium. As used herein, the phrase "anchor fixing circuit" is used in its broadest sense to mean any circuit, device or system that is capable of identifying a reproducible location relative to an identified media defect.

In some instances of the aforementioned embodiments, the circuit may further include a data processing circuit. As used herein, the phrase "data processing circuit" is used in its broadest sense to mean any circuit that is capable of applying a defined process to a data input to yield a data output. In some cases, the defined process is a data detector algorithm and/or a data decoder algorithm. In one particular case, a low density parity check decoder algorithm is used that converges on an appropriate result when the data input starts from a known location and does not have too many error bits. Based upon the disclosure provided herein, one of ordinary skill in the art will recognize a variety of data decoder and/or data detector circuits that may be used in relation to different embodiments of the present invention.

The data processing circuit may receive data that begins with a forced data sync mark in place of an original data sync mark that was not detected. Where the forced data sync mark is in the same location as the original data sync mark, the data processing circuit should converge when there are not too many data errors. In contrast, where the forced data sync mark is not in the same location as the original data sync mark, it is highly unlikely that the data processing circuit will converge. Thus, after identifying an anchor location corresponding to a media defect, some embodiments of the present invention repeatedly locate a forced data sync mark at different locations relative to the anchor location until the data processing circuit converges. Where the data processing circuit converges, it is assumed that the forced data sync mark has been located at the appropriate location. Once a forced data sync mark is identified that results in data convergence by the data processing circuit, the location of the forced data sync mark is stored to a buffer where it can be used on the next read of the storage medium in place of the undetectable original data sync mark.

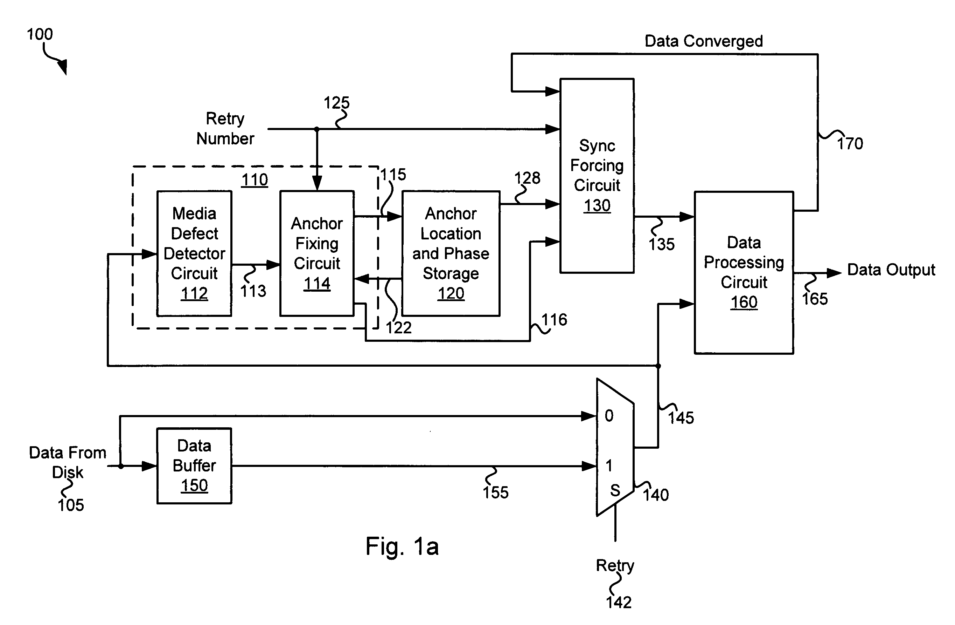

Turning to Fig. 1a, a read channel circuit 100 including anchor point circuitry and data sync mark forcing circuitry is shown in accordance with various embodiments of the present invention. Read channel circuit 100 includes an anchor location circuit 110. Anchor location circuit 110 has a media defect detector circuit 112 that receives data 105 derived from a disk or other storage medium via a multiplexer 140 as an output 145. In some cases, data 105 is a series of digital samples that may be received, for example, from an analog processing circuit (not shown) that is responsible for sensing information from a storage medium, filtering the information, and converting the information to a series of corresponding digital samples. Based upon the disclosure provided herein, one of ordinary skill in the art will recognize a variety of sources for data 105 and pre-processing circuitry.

Media defect detector circuit 112 is operable to receive multiplexer output 145 and to provide a media defect output 113 to an anchor fixing circuit 114. Media defect output 113 is asserted over a period corresponding to a detected defect on the medium from which data 105 was derived. Media defect detector circuit 112 may be any media defect detector circuit known in the art that is capable of providing an output indicating the occurrence of a defect on the medium from which data 105 was derived. Anchor fixing circuit 114 applies a filtering algorithm to media defect output 113 to determine whether the currently identified media defect is sufficiently reliable, along with the location and phase of the identified media defect. Where the currently identified media defect indicated by media defect output 113 is not sufficiently reliable, it is ignored and the next media defect is awaited. Alternatively, where the currently identified media defect indicated by media defect output 113 is sufficiently reliable, anchor fixing circuit 114 provides a defect and phase location output 115 to an anchor location and phase storage circuit 120. Anchor location and phase storage circuit 120 stores the received phase and location to be used as an anchor point for repeated forced data sync marks.

Anchor location and phase storage 120 provides a phase output 122 to anchor fixing circuit 114. Anytime a second or later retry is being processed as indicated by a retry number 125, anchor fixing circuit 114 only looks for the previously identified anchor point using the previously determined phase provided as phase output 122. Anchor location and phase storage 120 provides an anchor and phase output 128 to a sync forcing circuit 130 that provides a forced data sync output 135 relative to the received anchor and phase output 128.

Data 105 is also provided to a data buffer 150 that is of sufficient size to store at least one full encoded data set for decoding by a data processing circuit 160. As data 105 is initially received, a retry input 142 is set as a logic '0' such that data 105 is provided via a multiplexer 140 as a multiplexed output 145 to data processing circuit 160 and to media defect detector circuit 112. On this initial processing pass where the original data sync mark is detected, data processing circuit 160 processes data 105 to yield a data output 165. Alternatively, where the original data sync mark is not detected, a subsequent pass provides buffered data 155 from data buffer 150 to data processing circuit 160 and media defect detector circuit 112 via multiplexer 140.

On all retry passes as indicated by retry number 125, sync forcing circuit 130 provides a forced data sync mark 135 to data processing circuit 160. Forced data sync mark 135 is used on retry passes to indicate a reproducible beginning of the data in data buffer 150 that is to be processed by data processing circuit 160. Where data processing circuit 160 converges, the result is provided as data output 165 and a data converged output 170 is asserted indicating that the previously forced data sync mark worked. In such a case, sync forcing circuit 130 stores the previously forced data sync mark as a location relative to the anchor point. This location information can be used on subsequent accesses to the corresponding region of the storage medium. At this point, the retry process completes as the data was found.

Alternatively, where data processing circuit 160 does not converge, data converged signal 170 indicates the failure to converge to sync forcing circuit 130. In response, sync forcing circuit 130 forces a subsequent forced data sync mark a greater distance from the anchor point than the previously forced data sync mark. The data from data buffer 150 is re-processed by data processing circuit 160 as previously described. This process of repeatedly placing forced data sync marks at succeeding different distances from the previously identified anchor location received as part of output 128 and retrying the processing by data processing circuit 160 continues until either a time out condition is met or until a valid data sync mark location is identified (i.e., until data processing circuit 160 converges).

Turning to Fig. lb, a timing diagram 180 depicts an example operation of read channel circuit 100 in accordance with some embodiments of the present invention. Following timing diagram 180, data from the disk (i.e., output 145 from multiplexer 140) includes a 2T preamble 192 as is known in the art. 2T preamble 192 is a repetitive signal that may be used to synchronize the phase and frequency of a subsequent original data sync mark 194 and user data 188. User data is a known number of bits 198 that begins after sync mark 194. In some embodiments, known number of bits 198 is 4K bits. As shown, a media defect 186 occurs at a location where 2T preamble 192 is stored on the medium. It should be noted that read channel circuit will work where media defect 186 occurs anywhere in 2T preamble 192 and/or original data sync mark 194.

Media defect output 113 is asserted during a period 184 that corresponds to media defect 186. Once it is determined that the identified media defect is sufficiently reliable, anchor point 128 is stored for use in relation to forcing data sync marks. As shown, forced sync mark 135 eventually is placed at a location corresponding to original data sync mark 194. The location of forced sync mark 135 is a reproducible distance 190 from anchor point 128. As such, forced data sync mark 135 is stored and can be reproduced on subsequent accesses of user data 188. What is not shown is a number of forced sync marks that were tried. Because these earlier tried forced sync marks were not correct, data processing circuit 160 fails to converge resulting in the placement and try of a subsequent forced data sync mark. This process is repeated until the shown forced sync mark 135 corresponding to reproducible distance 190 from anchor point 128 is located.

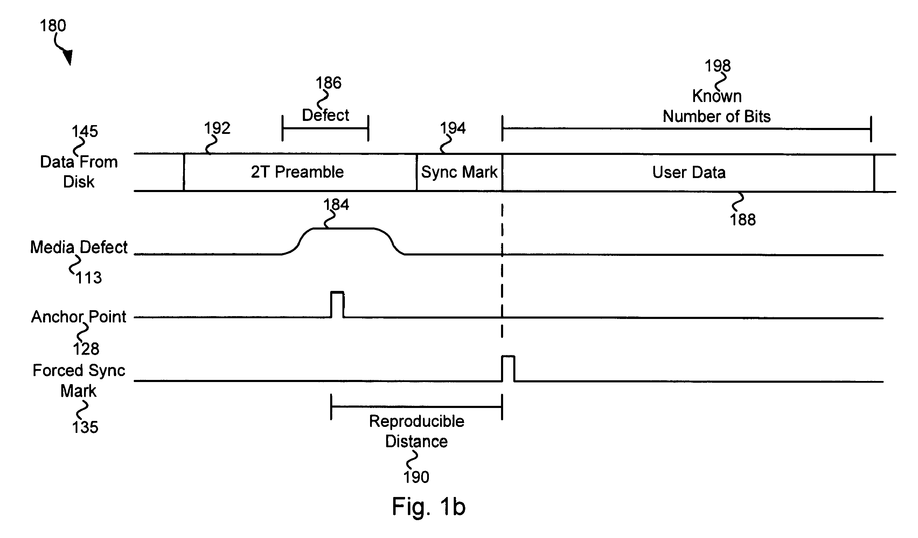

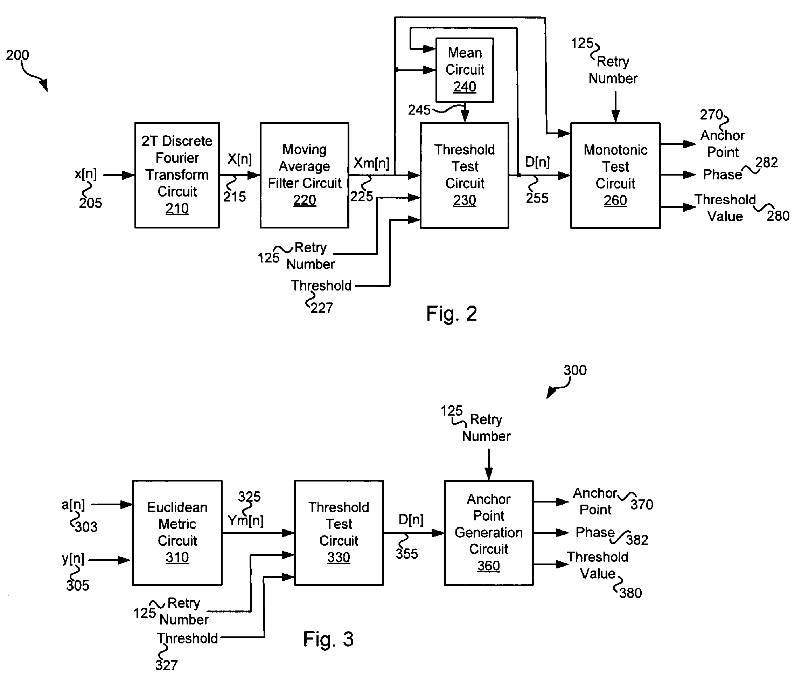

Turning to Fig. 2, a discrete Fourier transform based anchor location circuit 200 is shown in accordance with various embodiments of the present invention. Anchor location circuit 200 may be used in place of anchor location circuit 110 of Fig. 1. Anchor location circuit 200 includes a discrete Fourier transform circuit 210 that is tuned to a 2T frequency. Discrete Fourier transform circuit 210 may be any discrete Fourier transform circuit known in the art. As is known in the art, the 2T frequency is the fundamental frequency of the preamble pattern (i.e., '110011001100 ...') with a period 4T where T denotes the duration of one bit. Discrete Fourier transform circuit 210 receives a data input 205 (x[n]) and converts data input 205 to a frequency domain output 215 (X[n]). In one particular embodiment, data input 205 may be data output 145 from multiplexer 140 shown in Fig. 1a. Frequency domain output 215 is described by the following equation:

$$X[n] = | x[n-4] - x[n-2] + x[n] - x[n+2] | + | x[n-3] - x[n-1] + x[n+1] - x[n+3] | .$$

A moving average filter circuit 220 receives frequency domain output 215 and performs a moving average that is provided as an average output 225, $X_m[n]$. Moving average filter circuit 220 may be any moving average filter circuit known in the art. In one particular embodiment of the present invention, moving average filter circuit 220 may average four or eight instances of frequency domain output 215 to yield average output 225. Based upon the disclosure provided herein, one of ordinary skill in the art will recognize different numbers of instances of frequency domain output 215 that may be used in calculating average output 225. As an example, moving average filter circuit 220 may include a memory that maintains a defined number of the most recent instances of frequency domain output 215. The following equation describes average output 225:

$$X_m[n] = \frac{1}{\beta} \sum_{i=0}^{N-1} X[n-i],$$

where $\beta$ is equal to '1' when N is equal to '4', and $\beta$ is equal to '2' when N is equal to '8'.

A mean output 245, $X_{m,d}[n]$, is generated by a mean circuit 240 where mean output 245 is the mean of average output 225 as described by the following equations:

$$X_{m,d}[n] = X_{m,d}[n-1] + \gamma(X_m[n] - X_{m,d}[n-1]),$$

where a defect output 255 was not asserted on the preceding instance (i.e., D[n-1]='0');
and

$$X_{m,d}[n] = X_{m,d}[n-1],$$

where defect output 255 was asserted on the preceding instance (i.e., D[n-1]='1').
A threshold test circuit 230 asserts defect output 255 based upon a comparison of average output 225 with a threshold 227 multiplied by mean output 245. In particular, the following equation describes assertion of defect output 255 by threshold test circuit 230:

$$D[n] = '1' \text{ if } Xm[n] \le theshold * Xm,d[n];$$

$$D[n] = '0' \text{ otherwise.}$$

Defect output 255 and average output 225 are provided to a monotonic test circuit 260 that tests a detected output to determine if it is sufficiently reliable for establishing an anchor point. Monotonic test circuit 260 effectively tests subsequent data points to determine whether the detected defect condition continues. In particular instances, the detected media defect is considered sufficiently reliable where the following condition is met:

$$Xm[n_0 - 4 + i] > Xm[n_0 - 2 + i] > Xm[n_0 + i] > Xm[n_0 + 2 + i],$$

where no is the location where the aforementioned monotonic condition (i.e., reliability condition) is first met, and i is a positive integer with $i \in \{0,1,2,3,4...\}$. Let $i_0$ be the minimum value of i for which the above mentioned condition holds. Where monotonic test circuit 260 determines that the reliability condition has been met, the location of the determined monotonic condition, given by $n_1 = n_0 + i_0$ is provided as an anchor point 270, and a threshold value 280 at anchor point 270 is provided. Threshold value 280 is determined as:

$$\theta = \frac{Xm[n_1] + Xm[n_1 - 4]}{2}.$$

The quarter rate phase 282, $\varphi \in \{0,1,2,3\}$, on which the $n_1$ lies is also noted. In some cases, threshold 227 is programmable.

On subsequent passes (i.e., where retry number 125 indicates the second or later retry), the same process of establishing an anchor point may be used as it is repeatable. However, in some cases of the aforementioned embodiments, for subsequent retries the first defect 215 that satisfies the above described monotonic condition is identified. The starting location of this defect is referred to herein as $k_0$. With this condition met, the sample instant $k_1$ that occurs at the same phase 282 where anchor point 270 was established on the first pass is determined such that $k_1 \ge k_0$. From here it is determined whether the identified point meets the threshold value 280 that was established on the initial pass. In particular, the anchor point is described by the following equation:

$$anchor\ point = k_1 + 4 * i_1,$$

where $i_1$ is the minimum value of $i \in \{-1,0,1\}$ for which the threshold test is met. In particular, the threshold test is described by the following equation:

$$X_m[k_1 + 4 * i\ ] \le \Theta.$$

Such an approach may require substantially less processing when compared with the approach used to initially establish the anchor point, and in many cases will further guarantee that the original anchor point is found again.

Fig. 3 shows an end of preamble based anchor location circuit 300 in accordance with other embodiments of the present invention. Preamble based anchor location circuit 300 reuses a Euclidean metric circuit 310 that is included in a number of data detection circuits. As is known in the art, Euclidean metric circuit 310 calculates the Euclidean distance between a data input 305 and a baseline 303. In a particular embodiment, data input 305 is data output 145 from multiplexer 140 of Fig. 1. Where the baseline 303 corresponds to the preamble pattern, a Euclidean output 325, $Y_m[n]$, is asserted at a relatively low value when data input 305 is consistent with baseline 303; and Euclidean output 325 is asserted at a relatively high value when data input 305 deviates from baseline 303. Where Euclidean output 325 is asserted at the relatively low level for a substantially long period (e.g., between fourteen to twenty bit periods) followed by an increase in Euclidean value 325, an end of preamble is indicated. Under normal conditions, this end of preamble indicates the start of the original data sync mark. However, where a media defect occurs at a location where the preamble was originally written, the same increase in Euclidean value 325 occurs. Thus, where the decline in Euclidean value 325 is not followed by detection of an original data sync mark, it may be assumed that a reproducible media defect detection occurred. This reproducible media defect detection may be used to fix an anchor point that can be used as the basis of forced data sync marks similar to those discussed above in relation to Fig. 2.

Euclidean value 325 is provided to a threshold test circuit 330. Threshold test circuit 330 compares Euclidean value 325 with a threshold 327. Where Euclidean value 325 is greater than threshold 327, an end of preamble is declared (i.e., a defect output 355, D[n], is asserted). Anchor point generation circuit 360 provides an anchor point 370 that indicates the location, and a threshold value 380 at anchor point 370 is provided. The quarter rate phase 382, $\varphi \in \{0,1,2,3\}$, on which the anchor point lies is also noted. In some cases, threshold 327 is programmable. Threshold value 380 may be calculated by averaging the Euclidean values 325 that first exceeded threshold 327 and the maximum value of the Euclidean value 325 before the end of the preamble was detected.

On subsequent passes (i.e., where retry number 125 indicates the second or later retry), the same process of establishing an anchor point may be used as it is repeatable. However, in some cases of the aforementioned embodiments, for subsequent retries threshold 327 may be programmed to be the same value as threshold value 380 such that the anchor point is indicated whenever threshold value 380 is again identified. In every retry pass, the search for anchor-point is done in the same quarter-rate phase 382 that was identified in the first pass.

Threshold 327 may be set originally by programming a default value, but then may be dynamically updated with every retry pass. In the first pass, the maximum value of Euclidean value 325 prior to end-of-preamble detection point is recorded into a register MAX_VALUE. In each subsequent retry pass, this register is updated with the new maximum Euclidean value 325 prior to the end-of-preamble detection point if the new maximum for this pass is bigger than the content of register MAX_VALUE. In the current pass, if Euclidean value 325 is greater than threshold value 380, threshold value 380 for the next retry is set as:

$$threshold\ value\ 380 = (Euclidean\ Value\ 325 + MAX\ VALUE)/2.$$

Based on the discussion of the various embodiments of the present invention as illustrated in Fig.2 and Fig. 3, one of ordinary skill in the art will recognize that the anchor point detection circuits shown in Fig. 2 and Fig. 3 may successfully detect anchor point even in the absence of media defect in the input data. The actual data sync mark will cause the threshold test circuits 230 in Fig. 2 and 330 in Fig. 3 to assert detection of end-of preamble as a valid anchor point. While this happens by metric circuit Euclidean used in Fig. 2, it also happens in Fig. 3 since the 2T DFT value 215 over actual sync mark will be much less than that over 2T preamble pattern. Thus, the present invention can be used for location of anchor point whether or not media defect occurs.

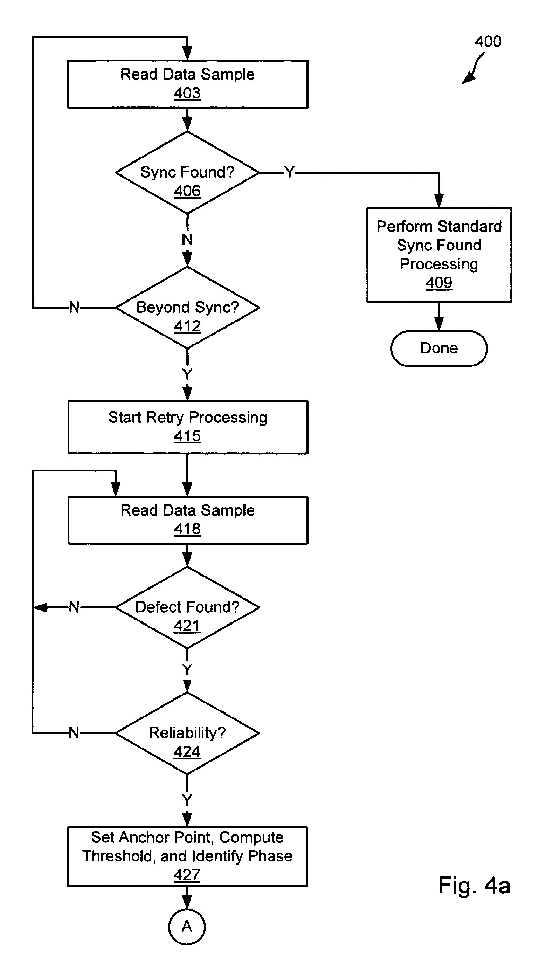

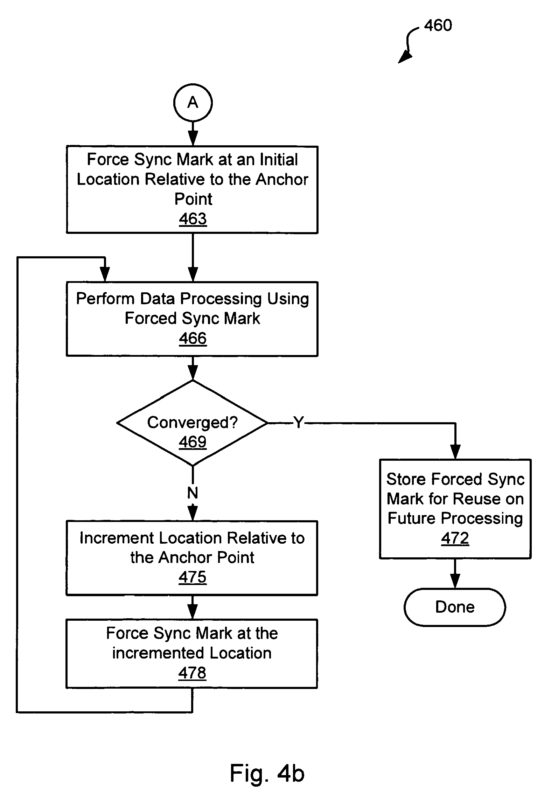

Turning to Fig. 4a and Fig. 4b, flow diagram 400 and flow diagram 460 show a method in accordance with some embodiments of the present invention for fixing an anchor point and forcing a data sync mark relative to the anchor point in accordance with one or more embodiments of the present invention. Following flow diagram 400, a data sample is read (block 403). The data sample may be a digital representation of information sensed from a storage medium. The data sample may be read either as a live data stream or from a buffer where a live data stream was previously buffered. The data sample is included in a larger series of data samples and compared to determine if an original sync mark has been identified (block 406). Where an original data sync mark is identified (block 406), standard processing is performed on the user data following the original data sync mark using the original data sync mark as an indication of where the codeword to be processed begins (block 409).

Alternatively, where an original data sync mark is not found (block 406), it is determined whether the search for the sync mark has already extended beyond where the sync mark would have been expected to be found (block 412). Where region where the sync mark was expected has not yet been passed (block 412), the process of searching for an original data sync mark is continued. Where, on the other hand it is determined that the region where the original data sync mark was expected has been passed (block 412), retry processing is started (block 415). Retry processing includes reading data samples from a buffer where they were stored during the original processing (block 418). These samples are provided to a defect detector circuit that processes the received data to determine whether a media defect is indicated (block 421). Where a defect is not found (block 421), the process of reading data samples and searching for a defect is continued. Alternatively, where a defect is found (block 421), the defect is tested to see if it is sufficiently reliable (i.e., exhibits monotonicity or passes a threshold test) (block 424). Where the defect is not found to be sufficiently reliable (block 421), the process of reading data samples and retesting for a defect and reliability is continued. Otherwise, where a defect is found to be sufficiently reliable (block 424), and anchor point (i.e., a location of the defect) is stored along with the phase of the sample where it was found (block 427) and a threshold is computed and stored for use in subsequent retry passes.

Following flow diagram 460, a sync mark is forced (i.e., forced sync mark) at an initial location relative to the previously determined anchor point (block 463). In some cases, this initial sync mark is forced at the same location as the anchor point. In other cases, the initial sync mark may be forced a reproducible distance from the anchor point. The data that follows the location of the forced sync mark is then processed using the forced sync mark as if it were an original data sync mark indicating the beginning of the user data (block 466). Such data processing may include, but is not limited to, low density parity check decoding and/or maximum a posteriori data detection as are known in the art. Based upon the disclosure provided herein, one of ordinary skill in the art will recognize various data processing approaches that may be applied to the read data.

It is determined whether the data processing converged (i.e., provided an expected result) (block 469). Where the data processing converged (block 469), the forced sync mark is assumed to be at the location of the original data sync mark and is stored for reuse on later accesses to the corresponding region of the media (block 472). Otherwise, where the data processing failed to converge (block 469), the location relative to the identified anchor point is incremented (block 475), and a sync mark is forced at the newly incremented location (block 478). This process of forcing sync marks continues until either a timeout condition is met or the data processing converges (block 469).

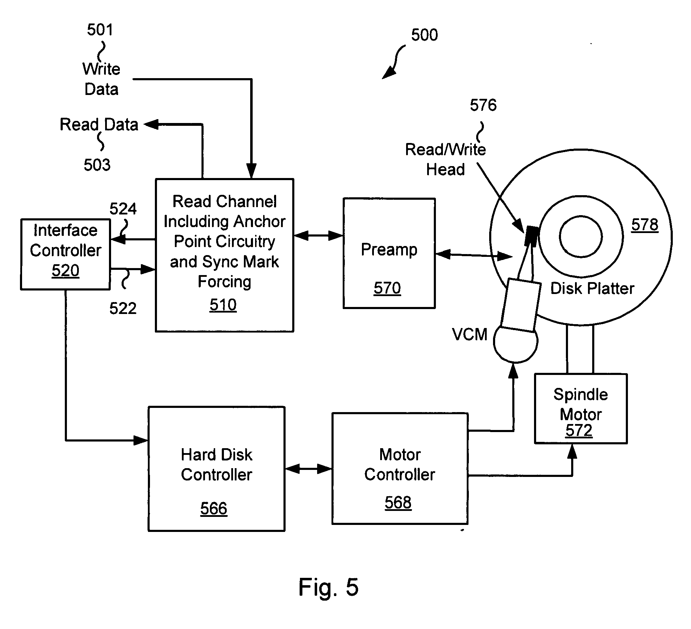

Turning to Fig. 5, a storage system 500 including a read channel 510 with anchor point circuitry and sync mark forcing is shown in accordance with various embodiments of the present invention. Storage system 500 may be, for example, a hard disk drive. Storage system 500 also includes a preamplifier 570, an interface controller 520, a hard disk controller 566, a motor controller 568, a spindle motor 572, a disk platter 578, and read/write heads 576. Interface controller 520 controls addressing and timing of data to/from disk platter 578. The data on disk platter 578 consists of groups of magnetic signals that may be detected by read/write head assembly 576 when the assembly is properly positioned over disk platter 578. In one embodiment, disk platter 578 includes magnetic signals recorded in accordance with a perpendicular recording scheme.

In a typical read operation, read/write head assembly 576 is accurately positioned by motor controller 568 over a desired data track on disk platter 578. Motor controller 568 both positions read/write head assembly 576 in relation to disk platter 578 and drives spindle motor 572 by moving read/write head assembly to the proper data track on disk platter 578 under the direction of hard disk controller 566. Spindle motor 572 spins disk platter 578 at a determined spin rate (RPMs). Once read/write head assembly 578 is positioned adjacent the proper data track, magnetic signals representing data on disk platter 578 are sensed by read/write head assembly 576 as disk platter 578 is rotated by spindle motor 572. The sensed magnetic signals are provided as a continuous, minute analog signal representative of the magnetic data on disk platter 578. This minute analog signal is transferred from read/write head assembly 576 to read channel module 510 via preamplifier 570. Preamplifier 570 is operable to amplify the minute analog signals accessed from disk platter 578. In turn, read channel module 510 decodes and digitizes the received analog signal to recreate the information originally written to disk platter 578. This data is provided as read data 503 to a receiving circuit. A write operation is substantially the opposite of the preceding read operation with write data 501 being provided to read channel module 510. This data is then encoded and written to disk platter 578.

The anchor point circuitry and sync mark forcing circuitry may be similar to those discussed above in relation to Figs. 1-3, and/or may operate similar to that discussed above in relation to Figs. 4a-4b. Such anchor point circuitry and sync mark forcing circuitry are capable of identifying a reproducible location on a medium, and forcing a sync mark at a location relative to the reproducible location as described herein.

In conclusion, the invention provides novel systems, devices, methods and arrangements for identifying a reproducible location on a storage medium. While detailed descriptions of one or more embodiments of the invention have been given above, various alternatives, modifications, and equivalents will be apparent to those skilled in the art without varying from the spirit of the invention. Therefore, the above description should not be taken as limiting the scope of the invention, which is defined by the appended claims.

**Claims**

1. A circuit for identifying a reproducible location on a storage medium, the circuit comprising:

   a media defect detector, wherein the media defect detector is operable to identify a media defect; and
   an anchor fixing circuit, wherein the anchor fixing circuit is operable to identify a location relative to the media defect, and wherein the location is reproducible.

2. The circuit of claim 1, wherein the media defect detector includes a discrete Fourier transform circuit.

3. The circuit of claim 2, wherein the discrete Fourier transform circuit is tuned to a 2T pattern.

4. The circuit of claim 1, wherein the media defect detector is operable to identify a media defect using a series of data samples derived from a storage medium, and wherein the circuit further comprises:

   a data processing circuit, wherein the data processing circuit is operable to process a subset of the series of data samples using a forced data sync mark that is a fixed distance from the location.

5. The circuit of claim 1, wherein the media defect detector includes an end of preamble detector circuit.

6. A method for identifying a reproducible location on a storage medium, the method comprising:

   receiving a series of data samples derived from a storage medium;
   identifying a media defect on the storage medium using the series of data samples; and
   fixing a location on the storage medium relative to the media defect, wherein the location is reproducible.

7. The method of claim 6, wherein the method further comprises:

   applying a decoding algorithm to a subset of the series of data samples using the location as a reference for the beginning of a decodable data set.

8. The method of claim 6, wherein the location is a first location, and wherein the method further comprises:

   applying a decoding algorithm to a first subset of the series of data samples using the first location as a reference for the beginning of a decodable data set, wherein the decoding algorithm fails to converge;
   fixing a second location on the storage medium relative to the media defect,
   wherein the second location is reproducible; and
   applying the decoding algorithm to a second subset of the series of data samples using the second location as a reference for the beginning of the decodable data set.

9. The method of claim 8, wherein application of the decoding algorithm using the second location converges, and wherein the method further comprises:

   storing a forced data sync mark in a memory, wherein the forced data sync mark indicates the second location and is usable on subsequent reads from the storage medium to indicate the beginning of the decodable data set on the storage medium.

10. The method of claim 6, wherein receiving a series of data samples derived from a storage medium includes accessing the series of data samples from a data buffer.

11. The method of claim 6, wherein the method further comprises:

accessing information from the storage medium; and
generating the series of data samples based upon the information.

12. A hard disk drive system, the hard disk drive system comprising:

a storage medium;
a media defect detector, wherein the media defect detector is operable to identify a media defect on the storage medium using a series of data samples derived from the storage medium; and
an anchor fixing circuit, wherein the anchor fixing circuit is operable to identify a location relative to the media defect, and wherein the location is reproducible.

13. The system of claim 12, wherein the media defect detector includes a circuit selected from a group consisting of: a discrete Fourier transform circuit, and an end of preamble detector circuit.

14. The system of claim 12, wherein the system further comprises:

a data processing circuit, wherein the data processing circuit is operable to process a subset of the series of data samples using a forced data sync mark that is a fixed distance from the location.

15. The circuit of claim 4 or the system of claim 14, wherein the system further comprises:

a sync forcing circuit, wherein the sync forcing circuit is operable to repeatedly identify forced data sync marks whenever the data processing circuit fails to converge, and to store the forced data sync mark when the data processing circuit converges, wherein the circuit or system optionally further comprises:

a data buffer, wherein the data buffer stores the forced data sync mark that is usable on subsequent reads from the storage medium to indicate the beginning of the decodable data set on the storage medium.

Fig. 1a

Fig. 1b

Fig. 2

Fig. 3

400

```
┌─────────────────────┐
│  Read Data Sample   │
│        403          │
└─────────────────────┘
          │
          ▼
      ╱───────╲
     ╱ Sync    ╲───Y──────────────┐
     ╲ Found?  ╱                   │
      ╲  406  ╱                    ▼
       ╲─────╱            ┌──────────────────┐
          N               │ Perform Standard │
          ▼               │   Sync Found     │
      ╱───────╲           │   Processing     │
     ╱ Beyond  ╲──N──     │      409         │
     ╲ Sync?   ╱          └──────────────────┘
      ╲  412  ╱                    │
       ╲─────╱                     ▼
          Y                    ╭───────╮
          ▼                    │ Done  │
┌─────────────────────┐        ╰───────╯
│ Start Retry Processing│
│         415          │
└─────────────────────┘
          │
          ▼
┌─────────────────────┐
│  Read Data Sample   │
│        418          │
└─────────────────────┘
          │
          ▼
      ╱───────╲
     ╱ Defect  ╲──N──
     ╲ Found?  ╱
      ╲  421  ╱
       ╲─────╱
          Y
          ▼
      ╱───────╲
     ╱ Reliability? ╲──N──
     ╲    424      ╱
      ╲───────────╱
          Y
          ▼
┌──────────────────────────┐
│ Set Anchor Point, Compute│
│ Threshold, and Identify Phase│
│           427            │
└──────────────────────────┘
          │
          ▼
        ╭───╮
        │ A │
        ╰───╯
```

Fig. 4a

460

A

Force Sync Mark at an Initial
Location Relative to the Anchor
Point
463

Perform Data Processing Using
Forced Sync Mark
466

Converged?
469

—Y—

Store Forced Sync
Mark for Reuse on
Future Processing
472

Done

N

Increment Location Relative to
the Anchor Point
475

Force Sync Mark at the
incremented Location
478

Fig. 4b

501

Write
Data

Read Data

503

**Interface Controller**
**520**

524

522

**Read Channel Including Anchor Point Circuitry and Sync Mark Forcing**
**510**

**Preamp**
**570**

576

Read/Write
Head

**578**

Disk Platter

VCM

**Hard Disk Controller**
**566**

**Motor Controller**
**568**

**Spindle Motor**
**572**

500

Fig. 5

**EP 2 360 696 A1**

Europäisches
Patentamt
European
Patent Office
Office européen
des brevets

## EUROPEAN SEARCH REPORT

Application Number

EP 10 25 1369

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ECMA : STANDARDIZING INFORMATION AND COMMUNICATION SYSTEMS: "Standard ECMA-272 : 120 mm DVD Rewritable Disk (DVD-RAM)" STANDARD ECMA,, no. 272, 1 February 1998 (1998-02-01), pages 43-51, XP002114221 * paragraph [17.4] - paragraph [17.5] * ----- | 1,6 | INV. G11B20/18 G11B5/596 |
| X | EP 1 096 491 A1 (IOMEGA CORP [US]) 2 May 2001 (2001-05-02) * abstract * * paragraph [0017] - paragraph [0051] * ----- | 1-7, 10-14 | |
| A | Bagul, Y., G.: "Assesment of current health and remaining useful life of hard disk drives" Northeastern University Digital Library<br><br>1 January 2009 (2009-01-01), pages 5-6, XP002605138 Boston, MA Retrieved from the Internet: URL:http://iris.lib.neu.edu/cgi/viewcontent.cgi?article=1000&context=comp_sys_eng_theses [retrieved on 2010-10-14] * paragraphs [02.1], [0001] * ----- | 1-15 | TECHNICAL FIELDS SEARCHED (IPC)<br><br>G11B H03M |
| X<br>A | US 2008/168315 A1 (MEAD JOHN P [US] ET AL) 10 July 2008 (2008-07-10) * the whole document * * paragraph [0035] * ----- | 1-3,5-8, 10-14<br>4,9,15 | |
| X | EP 0 549 151 A2 (ADVANCED MICRO DEVICES INC [US]) 30 June 1993 (1993-06-30) * the whole document * ----- -/-- | 1-15 | |

The present search report has been drawn up for all claims

| Place of search | Date of completion of the search | Examiner |
|---|---|---|
| The Hague | 15 October 2010 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

19

Europäisches
Patentamt

European
Patent Office

Office européen
des brevets

# EUROPEAN SEARCH REPORT

Application Number

EP 10 25 1369

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/31651 A1 (SEAGATE TECHNOLOGY LLC [US]) 3 May 2001 (2001-05-03) | 1,6 | |
| A | * the whole document * ----- | 2-5,7-15 | |
| A | Galbraith, R., Oenning, T.: "Iterative Detection Read Channel Technology in Hard Disk Drives" Hitachi Global Storage Technologies <br><br> 1 October 2008 (2008-10-01), pages 1-4, XP002605139 Retrieved from the Internet: URL:http://www.hitachigst.com/tech/techlib.nsf/techdocs/FB376A33027F5A5F862575090014 63AE/$file/IDRC_WP_final.pdf [retrieved on 2010-10-14] * the whole document * ----- | 1-15 | |
| X,P | WO 2010/051000 A1 (LSI CORP [US]; LEE YUAN XING [US]; SAI FUMINORI [JP]; YANG SHAOHUA [US) 6 May 2010 (2010-05-06) * the whole document * ----- | 1,6,12 | TECHNICAL FIELDS SEARCHED (IPC) |

The present search report has been drawn up for all claims

| Place of search | Date of completion of the search | Examiner |
|---|---|---|
| The Hague | 15 October 2010 | Belardinelli, Carlo |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

................................................................

& : member of the same patent family, corresponding
      document

EPO FORM 1503 03.82 (P04C01)

**EP 2 360 696 A1**

**ANNEX TO THE EUROPEAN SEARCH REPORT
ON EUROPEAN PATENT APPLICATION NO.**                    EP 10 25 1369

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2010

| Patent document cited in search report | | Publication date | Patent family member(s) | | Publication date |
|---|---|---|---|---|---|
| EP 1096491 | A1 | 02-05-2001 | JP 2001184807 A | | 06-07-2001 |
| | | | US 6557113 B1 | | 29-04-2003 |
| US 2008168315 | A1 | 10-07-2008 | NONE | | |
| EP 0549151 | A2 | 30-06-1993 | JP 5242611 A | | 21-09-1993 |
| WO 0131651 | A1 | 03-05-2001 | CN 1390352 A | | 08-01-2003 |
| | | | DE 10085084 T0 | | 21-11-2002 |
| | | | GB 2369483 A | | 29-05-2002 |
| | | | JP 2003513399 T | | 08-04-2003 |
| WO 2010051000 | A1 | 06-05-2010 | US 2010115209 A1 | | 06-05-2010 |

EPO FORM P0459

For more details about this annex : see Official Journal of the European Patent Office, No. 12/82

21